# EUROPÄISCHE PATENTSCHRIFT

(11) **EP 3 743 943 B1**
(45) Veröffentlichungstag und Bekanntmachung des Hinweises auf die Patenterteilung: **11.02.2026**
(21) Anmeldenummer: 18825882.6
(22) Anmeldetag: 05.12.2018
(51) Int. Cl.: H01L 23/14, H01L 23/498, H05K 3/40, H05K 3/44

(54) **SCHALTUNGSTRÄGERANORDNUNG MIT VERBESSERTER ELEKTRISCHER KONTAKTIERUNG**
CIRCUIT SUBSTRATE ARRANGEMENT WITH IMPROVED ELECTRICAL CONTACT
DISPOSITIF DE SUPPORT DE CIRCUIT COMPRENANT UN CONTACT ÉLECTRIQUE AMÉLIORÉ

(30) Priorität: 23.01.2018 DE 102018201022
(43) Veröffentlichungstag der Anmeldung: 02.12.2020
(73) Patentinhaber: Robert Bosch GmbH, 70442 Stuttgart (DE)
(72) Erfinder: WIESA, Thomas, 71665 Vaihingen (DE); MEIER, Andreas, 72793 Pfullingen (DE); HUEHNER, Stefan, 72127 Kusterdingen (DE)
(86) Internationale Anmeldenummer: PCT/EP2018/083617
(87) Internationale Veröffentlichungsnummer: WO 2019/145077

(56) Entgegenhaltungen:
- EP-A1- 0 298 855
- JP-A- S5 843 595
- JP-U- H0 221 776
- US-A- 5 189 261
- US-B1- 6 747 217

## Beschreibung

### Stand der Technik

Die vorliegende Erfindung betrifft eine Schaltungsträgeranordnung mit einer signifikant verbesserten elektrischen Kontaktierung.

Schaltungsträgeranordnungen sind aus dem Stand der Technik in unterschiedlichen Ausgestaltungen bekannt. Beispielsweise sind sog. IMS (isolated metal substrate) in Form von einlagigen oder mehrlagigen Leiterplatten bekannt, welche auf einem Metallsubstrat, insbesondere Kupfer oder Aluminium enthaltend laminiert sind. Dieses Metallsubstrat ermöglicht eine bessere thermische Spreizung der Verlustleistung. Hierbei sind jedoch Kupfer basierte IMS deutlich teurer als Aluminium basierte IMS, bei sonst gleichem Aufbau. Neben der Basisschicht umfasst das IMS ferner noch eine Kupfer basierte Schaltungsschicht und eine dielektrische Zwischenschicht zwischen der Basisschicht und der Schaltungsschicht. Falls die Basisschicht eine Aluminium basierte Schicht ist, ergeben sich jedoch elektrische Kontaktprobleme zwischen den auf unterschiedlichen Metallsubstraten basierenden Basisschicht (Aluminium) und der Schaltungsschicht (Kupfer).

Ein aus JPS5843595A bekanntes Verbindungselement in Form eines Niets stellt über eine vollständig ausgefüllte Öffnung eine elektrische Verbindung zwischen Leiterbahn und Metallkern her. Aus JPH0221776U ist ein Niet bekannt, der in die metallische Trägerschicht eingepresst ist und mit der Leiterbahnschicht verlötet wird.

### Offenbarung der Erfindung

Die erfindungsgemäße Schaltungsträgeranordnung mit den Merkmalen des Anspruchs 1 weist demgegenüber den Vorteil auf, dass eine verbesserte Kontaktierung bei unterschiedlichen Metallsubstraten der Schaltungsträgeranordnung möglich ist. Hierbei kann eine Aluminium umfassende Basisschicht und eine Kupfer umfassende Schaltungsschicht verwendet werden, welche durch eine dielektrische Zwischenschicht voneinander getrennt sind. Die elektrische Kontaktierung kann dabei sehr einfach und kostengünstig ausgeführt werden und ermöglicht eine besonders hohe Robustheit, was zu großen Vorteilen, insbesondere bei Verwendung in bewegten Einrichtungen, wie beispielsweise Fahrzeugen, führt. Erfindungsgemäß ist hierbei ein elektrischer Kontakt zwischen der Aluminium umfassenden Basisschicht und der Kupfer umfassenden Schaltungsschicht mit einer Niet vorgesehen, wobei zwischen der Niet und der Basisschicht eine kraftschlüssige Verbindung ausgebildet ist und zwischen der Niet und der Schaltungsschicht eine stoffschlüssige Verbindung ausgebildet ist. Somit wird die Niet durch zwei unterschiedliche Verbindungen mit den beiden unterschiedlichen Metallschichten verbunden. Die Schaltungsträgeranordnung weist eine Öffnung auf, in welcher die Niet angeordnet ist. Somit kann für die Schaltungsträgeranordnung problemlos die kostengünstigere Aluminium umfassende Basisschicht verwendet werden, so dass sich ein breites Einsatzspektrum ergibt, da die elektrische Kontaktierung zwischen den unterschiedlichen Metallsubstraten deutlich verbessert werden kann.

Die Unteransprüche zeigen bevorzugte Weiterbildungen der Erfindung.

Die Öffnung ist vorzugsweise eine Durchgangsöffnung. Die Öffnung wird vorzugsweise nach Zusammensetzen der drei Schichten der Schaltungsträgeranordnung eingebracht. Alternativ ist die Öffnung ein Sackloch.

Weiter bevorzugt ist hierbei eine Länge der Niet kleiner als eine Länge der Öffnung. Hierdurch ergibt sich wenigstens ein Raumbereich in der Öffnung der Schaltungsträgeranordnung, welcher nicht durch die Niet besetzt ist. Dadurch ergeben sich unterschiedliche Gestaltungsmöglichkeiten. Zum einen kann die Niet nur teilweise in der Basisschicht angeordnet sein und/oder nur teilweise in der Schaltungsschicht angeordnet sein. Hierdurch ergeben sich am ersten und zweiten Ende der Niet Freiräume, welche für unterschiedliche Zwecke verwendet werden können.

Besonders bevorzugt umfasst die Niet einen Kopf, insbesondere einen flachen Kopf. Der Kopf liegt besonders bevorzugt auf der Schaltungsschicht auf. Zwischen dem Kopf und der Schaltungsschicht ist bevorzugt die stoffschlüssige Verbindung ausgebildet.

Die stoffschlüssige Verbindung wird bevorzugt mittels eines Lots hergestellt.

Alternativ ist die Niet in Form eines Stiftes ohne Kopf, so dass die Niet vollständig in der Öffnung in der Schaltungsträgeranordnung angeordnet werden kann. Besonders bevorzugt ist dabei ein erstes Ende der Niet bündig mit einer Oberfläche der Schaltungsschicht abschließend, wobei das Lot der stoffschlüssigen Verbindung dann das erste Ende der Niet vollständig überdeckt. Alternativ ist das erste Ende der Niet derart in der Öffnung versenkt angeordnet, dass die Niet nur teilweise mit der Wandung der Öffnung in der Schaltungsschicht in Kontakt ist, so dass sich ein mit Lot gefüllter Raumbereich der Öffnung an der stoffschlüssigen Verbindung zwischen der Niet und der Schaltungsschicht ergibt. Besonders bevorzugt geht das Lot dabei über einen Randbereich der Öffnung an der Schaltungsschicht hinaus, um eine sichere elektrische Kontaktierung zwischen der Niet und der Schaltungsschicht zu ermöglichen.

Die erfindungsgemäße Schaltungsträgeranordnung wird besonders bevorzugt bei einem DC/DC-Konverter verwendet, insbesondere in Verbindung mit elektrischen Maschinen.

### Zeichnung

Nachfolgend werden Ausführungsbeispiele der Erfindung unter Bezugnahme auf die begleitende Zeichnung im Detail beschrieben. In der Zeichnung ist:
- Figur 1: eine schematische, perspektivische Darstellung einer Schaltungsträgeranordnung, die nicht Teil der Erfindung ist,
- Figur 2: eine schematische Schnittansicht der Schaltungsträgeranordnung von Figur 1, die nicht Teil der Erfindung ist,
- Figur 3: eine schematische Schnittansicht einer Schaltungsträgeranordnung gemäß einem Ausführungsbeispiel der Erfindung, und
- Figur 4: eine schematische Schnittansicht einer Schaltungsträgeranordnung, die nicht Teil der Erfindung ist.

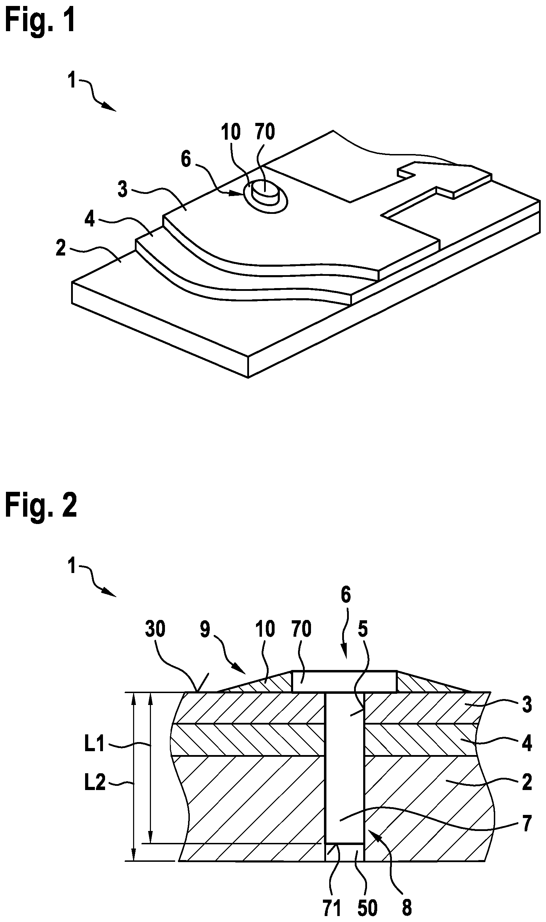

Nachfolgend wird unter Bezugnahme auf die Figuren 1 und 2 eine Schaltungsträgeranordnung 1, die nicht Teil der Erfindung ist, im Detail beschrieben. Wie aus Figur 1 ersichtlich ist, ist die Schaltungsträgeranordnung 1 ein sog. IMS (insulated metal substrate) mit einer Aluminium umfassenden Basisschicht 2, einer dielektrischen Schicht 4 und einer Kupfer umfassenden Schaltungsschicht 3.

Die dielektrische Schicht 4 ist als Zwischenschicht zwischen der Basisschicht 2 und der Schaltungsschicht 3 angeordnet und trennt diese beiden Schichten elektrisch. Hierbei ist die dielektrische Schicht 4 direkt auf der Basisschicht 2 aufgebracht und die Schaltungsschicht 3 ist direkt auf der dielektrischen Schicht 4 aufgebracht.

Durch die Verwendung einer Aluminium basierten Basisschicht kann im Vergleich mit anderen Materialien für die Basisschicht eine besonders kostengünstige Schaltungsträgeranordnung 1 bereitgestellt werden, wobei insbesondere hohe Wärmeleistungen durch die Aluminium umfassende Basisschicht 2 sicher abgeleitet werden können. Dies ist insbesondere in Verbindung mit elektronischen Hochleistungs-Bauteilen, z.B. MOSFET's, IGBT's, Trafos und/oder Spulen, von großem Vorteil. Somit kann ein Hitzestau an den elektronischen Hochleistungs-Bauteilen vermieden werden.

Die Verwendung der Aluminium basierten Basisschicht 2 weist beispielsweise im Vergleich mit der Verwendung von Kupfer basierten Basisschichten einen signifikanten Preisvorteil auf, wobei in Praxis fast die gleichen Wärmeleitfähigkeiten der Basisschichten erreicht werden.

Wie im Detail in Figur 2 gezeigt, umfasst die Schaltungsträgeranordnung 1 ferner wenigstens eine, bevorzugt mehrere Öffnungen 5, welche als

Durchgangsöffnungen durch die Schaltungsträgeranordnung 1 vorgesehen sind, wobei eine Mittelachse der Öffnung 5 senkrecht zu einer Oberfläche der Schaltungsträgeranordnung 1 ist.

Um eine elektrische Verbindung zwischen der Schaltungsschicht 3 und der Basisschicht 2 herzustellen, ist ein elektrischer Kontakt 6 vorgesehen, welcher eine Niet 7 umfasst. Die Niet 7 in diesem Ausführungsbeispiel ist eine zylindrische Niet aus einem Vollmaterial, welche einen Kopf 70 aufweist. Wie in Figur 2 gezeigt, liegt der Kopf 70 im montierten Zustand auf einer Oberfläche 30 der Schaltungsschicht 3 auf.

Der elektrische Kontakt 6 ist nun mit zwei unterschiedlichen Verbindungsarten mit der Basisschicht 2 und der Schaltungsschicht 3 verbunden. Hierbei ist zwischen der Niet 7 und der Basisschicht 2 eine kraftschlüssige Verbindung 8 vorgesehen und zwischen der Schaltungsschicht 3 und der Niet 7 eine stoffschlüssige Verbindung 9 vorgesehen. Die stoffschlüssige Verbindung ist in diesem Ausführungsbeispiel am Kopf 70 der Niet ausgebildet. Die stoffschlüssige Verbindung wird dabei mittels eines Lots 10, welches entlang des äußeren Umfangs des Kopfes 70 angeordnet wird, hergestellt.

Wie weiter aus Figur 2 ersichtlich ist, weist die Niet 7 eine erste Länge L1 auf und die Öffnung 5 in der Schaltungsträgeranordnung 1 eine zweite Länge L2 auf. Hierbei ist die erste Länge L1 kleiner als die zweite Länge L2. Hierdurch ergibt sich in der Öffnung 5 an einem ersten Ende 71 ein nicht von der Niet 7 ausgefüllter Bereich 50.

Die elektrische Kontaktierung über die kraftschlüssige Verbindung 8 zwischen der Basisschicht 2 und der Niet 7 ermöglicht dabei eine sehr gute elektromagnetische Verträglichkeit mit reduziertem Störpotential.

Die Niet 7 ist vorzugsweise aus Messing oder Kupfer hergestellt und weist eine beschichtete Oberfläche, vorzugsweise eine Gold- oder Zinnbeschichtung, auf.

Die stoffschlüssige Verbindung 9 mittels des Lots 10 wird besonders bevorzugt mittels eines Reflow-Lötprozesses ausgeführt.

Somit wird bei der Schaltungsträgeranordnung 1 eine elektrische Kontaktierung über zwei unterschiedliche Verbindungsarten, nämlich eine kraftschlüssige Verbindung 8 zur Verbindung mit der Basisschicht 2 und eine stoffschlüssige Verbindung 9 zur Verbindung mit der Schaltungsschicht 3 erhalten, welche eine besonders robuste elektrische Kontaktierung zwischen Schichten erreicht, die aus unterschiedlichen Materialien, nämlich die Basisschicht, die im Wesentlichen aus Aluminium hergestellt ist und die Schaltungsschicht 3, die im Wesentlichen aus Kupfer hergestellt ist, erreicht.

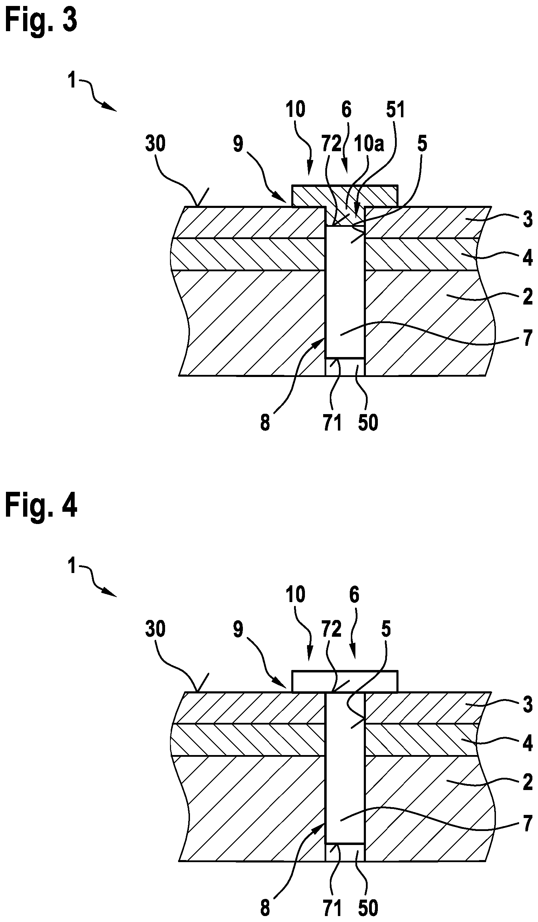

Figur 3 zeigt eine Schaltungsträgeranordnung 1 gemäß einem Ausführungsbeispiel der Erfindung, wobei gleiche bzw. funktional gleiche Teile mit den gleichen Bezugszeichen bezeichnet sind. Wie aus Figur 3 ersichtlich ist, ist die die Niet 7 des elektrischen Kontaktes 6 hierbei ausschließlich eine zylindrische Niet ohne Kopf. Hierbei ist die Niet 7 vollständig in der Öffnung 5 versenkt. Hierbei bleibt der erste Bereich 50 am ersten Ende 71 der Niet 7 in der Öffnung frei und auch ein zweiter Bereich 51 an dem freien bzw. zweiten Ende 72 der Niet 7 frei. Im Bereich 51 ist dann im Endzustand ein Lotbereich 10a des Lots 10 der stoffschlüssigen Verbindung 9 vorhanden und füllt diesen Bereich 51 aus, wie in Figur 3 schematisch gezeigt.

Figur 4 zeigt eine Schaltungsträgeranordnung 1, die nicht Teil der Erfindung ist, welches im Wesentlichen Ausführungsbeispiel entspricht. Die Niet 7 ist ebenfalls ohne Kopf und mit zylindrischer geometrischer Gestalt vorgesehen. Hierbei ist jedoch das zweite Ende 72 der Niet 7 bündig mit einer Oberfläche 30 der Schaltungsschicht 3 angeordnet. Das Lot 10 der stoffschlüssigen Verbindung 9 überdeckt dabei das zweite Ende der Niet 7 und stellt den elektrischen Kontakt zur Schaltungsschicht 3 her.

Somit kann gemäß der Erfindung, wie in den bevorzugten Ausführungsbeispiel gezeigt, eine sehr kostengünstige Leiterplatte mit einer Aluminium basierten Basisschicht 2 und einer Kupfer basierten Schaltungsschicht 3 hergestellt werden. Die elektrische Kontaktierung zwischen der Basisschicht 2 und der Schaltungsschicht 3 erfolgt dabei über eine Niet 7, welche einmal kraftschlüssig und einmal stoffschlüssig angebunden wird.

## Patentansprüche

1. Schaltungsträgeranordnung, umfassend:
- eine Aluminium umfassende Basisschicht (2),
- eine Kupfer umfassende Schaltungsschicht (3),
- eine zwischen der Basisschicht (2) und der Schaltungsschicht (3) angeordnete dielektrische Schicht (4),
- eine durch die Basisschicht (2), die Schaltungsschicht (3) und die dielektrische Schicht (4) verlaufende Öffnung (5), und
- einen elektrischen Kontakt (6) zwischen der Basisschicht (2) und der Schaltungsschicht (3), wobei der elektrische Kontakt (6) eine Niet (7) umfasst,
- wobei zwischen der Niet (7) und der Basisschicht (2) eine kraftschlüssige Verbindung (8) ausgebildet ist, und
- wobei zwischen der Niet (7) und der Schaltungsschicht (3) eine stoffschlüssige Verbindung (9) ausgebildet ist,
wobei die Niet (7) eine zylindrische Form ohne Kopf aufweist,
**dadurch gekennzeichnet, dass** ein freies Ende (72) der Niet (7) in der Öffnung (5) der Schaltungsträgeranordnung derart angeordnet ist, dass ein Bereich (51) in der Öffnung (5) vorgesehen ist, welcher mit Lot (10a) der stoffschlüssigen Verbindung (9) gefüllt ist.

2. Schaltungsträgeranordnung nach Anspruch 1, wobei die Öffnung (5) eine Durchgangsöffnung ist.

3. Schaltungsträgeranordnung nach einem der vorhergehenden Ansprüche, wobei eine erste Länge (L1) der Niet (7) kleiner ist als eine zweite Länge (L2) der Öffnung (5).

4. Schaltungsträgeranordnung nach einem der vorhergehenden Ansprüche, wobei das Lot (10) der stoffschlüssigen Verbindung (9) über die Öffnung (5) hinausgeht und eine elektrische Kontaktierung an der Oberfläche (30) der Schaltungsschicht (3) herstellt.

## Claims

1. Circuit carrier arrangement, comprising:
- a base layer (2) which comprises aluminium,
- a circuit layer (3) which comprises copper,
- a dielectric layer (4) which is arranged between the base layer (2) and the circuit layer (3),
- an opening (5) which runs through the base layer (2), the circuit layer (3) and the dielectric layer (4), and
- an electrical contact (6) between the base layer (2) and the circuit layer (3), wherein the electrical contact (6) comprises a rivet (7),
- wherein a force-fitting connection (8) is formed between the rivet (7) and the base layer (2), and
- wherein a cohesive connection (9) is formed between the rivet (7) and the circuit layer (3),
wherein the rivet (7) has a cylindrical shape without a head,
**characterized in that** a free end (72) of the rivet (7) is arranged in the opening (5) of the circuit carrier arrangement in such a way that a region (51) which is filled with solder (10a) of the cohesive connection (9) is provided in the opening (5).

2. Circuit carrier arrangement according to Claim 1, wherein the opening (5) is a passage opening.

3. Circuit carrier arrangement according to either of the preceding claims, wherein a first length (L1) of the rivet (7) is smaller than a second length (L2) of the opening (5).

4. Circuit carrier arrangement according to one of the preceding claims, wherein the solder (10) of the cohesive connection (9) goes beyond the opening (5) and establishes an electrical contact-connection on the surface (30) of the circuit layer (3).

## Revendications

1. Dispositif de support de circuit, comprenant :
- une couche de base (2) comprenant de l'aluminium,
- une couche de circuit (3) comprenant du cuivre,
- une couche diélectrique (4) disposée entre la couche de base (2) et la couche de circuit (3),
- une ouverture (5) qui s'étend à travers la couche de base (2), la couche de circuit (3) et la couche diélectrique (4), et
- un contact électrique (6) entre la couche de base (2) et la couche de circuit (3), le contact électrique (6) comprenant un rivet (7),
- une liaison par complémentarité de force (8) étant formée entre le rivet (7) et la couche de base (2), et
- une liaison par complémentarité de matière (9) étant formée entre le rivet (7) et la couche de circuit (3),
le rivet (7) présentant une forme cylindrique sans tête,
**caractérisé en ce qu'**une extrémité libre (72) du rivet (7) est disposée dans l'ouverture (5) du dispositif de support de circuit de telle sorte qu'une zone (51) remplie de brasure (10a) de la liaison par complémentarité de matière (9) est prévue dans l'ouverture (5).

2. Dispositif de support de circuit selon la revendication 1, dans lequel l'ouverture (5) est une ouverture traversante.

3. Dispositif de support de circuit selon l'une quelconque des revendications précédentes, dans lequel une première longueur (L1) du rivet (7) est inférieure à une deuxième longueur (L2) de l'ouverture (5).

4. Dispositif de support de circuit selon l'une quelconque des revendications précédentes, **caractérisé en ce que** la brasure (10) de la liaison par complémentarité de matière (9) s'étend au-delà de l'ouverture (5) et produit une mise en contact électrique avec la surface (30) de la couche de circuit (3).
